**Europäisches Patentamt**

**European Patent Office**

**Office européen des brevets**

(11) Numéro de publication : **0 319 414 B1**

(12) # FASCICULE DE BREVET EUROPEEN

(45) Date de publication du fascicule du brevet :
25.03.92 Bulletin 92/13

(51) Int. Cl.$^5$ : **G11C 27/02**

(21) Numéro de dépôt : **88403026.3**

(22) Date de dépôt : **01.12.88**

(54) **Dispositif perfectionné pour l'échantillonnage de signaux.**

(30) Priorité : **02.12.87 FR 8716848**

(43) Date de publication de la demande :
**07.06.89 Bulletin 89/23**

(45) Mention de la délivrance du brevet :
**25.03.92 Bulletin 92/13**

(84) Etats contractants désignés :
**DE GB IT NL**

(56) Documents cités :
**FR-A- 2 453 471**
**US-A- 3 641 563**
**US-A- 4 691 125**

(73) Titulaire : **INSTITUT FRANCAIS DU PETROLE**
**4, Avenue de Bois Préau**
**F-92502 Rueil-Malmaison (FR)**

(72) Inventeur : **Beauducel, Claude**
**8, rue Talon**
**F-60119 Henonville (FR)**

Jouve, 18, rue Saint-Denis, 75001 PARIS

## Description

La présente invention a pour objet un dispositif d'échantillonnage perfectionné pour minimiser les erreurs affectant les échantillons de signaux successivement mémorisés.

L'acquisition d'un signal par une chaîne de numérisation comporte généralement l'application à l'entrée d'un convertisseur analogique-numérique (analog-to-digital converter), d'échantillons de signaux prélevés sur le signal avec une fréquence d'échantillonnage déterminée et la mémorisation de chacun d'eux pendant un intervalle de temps suffisant pour sa conversion en un mot numérique. Le prélèvement d'échantillons de signaux et leur mémorisation sont réalisés par des circuits électroniques bien connus des spécialistes et désignés par échantillonneurs-bloqueurs (sample-and-hold circuits).

Pour des raisons diverses tenant aux imperfections des éléments constitutifs des échantillonneurs-bloqueurs, les amplitudes des échantillons mémorisés sont affectées d'erreurs. Il peut s'agir d'erreurs systématiques ou bien encore d'erreurs dynamiques dépendant de l'amplitude des variations d'amplitude des échantillons de signaux successifs. Dans ce cas, on observe que l'amplitude d'un échantillon de signal n'est pas indépendante de la valeur mémorisée de l'échantillon précédent. Le pouvoir séparateur d'un échantillonneur-bloqueur est défini par un taux dit de diaphonie dont les valeurs usuelles sont de l'ordre de - 80 dB. Dans certains cas, notamment dans le domaine de la prospection sismique où l'on procède à une numérisation précise des échantillons mémorisés, le taux de diaphonie entre échantillons doit être très inférieur à ces valeurs usuelles.

Par le brevet français n° 2.453.471 (correspondant au brevet US-A-4 352 070), on connaît un échantillonneur-bloqueur comportant un condensateur pour mémoriser des échantillons de tension électrique et des moyens pour charger le condensateur de mémorisation avec la tension à mémoriser durant des périodes d'échantillonnage et pour isoler celui-ci durant des périodes de blocage. Cet échantillonneur-bloqueur comporte un circuit passif de compensation comprenant un second condensateur, adapté à reproduire les caractéristiques réelles du condensateur de mémorisation, ce circuit étant connecté entre la sortie de l'échantillonneur-bloqueur et la masse, des moyens pour court-circuiter par intermittence le second condensateur et des moyens pour soustraire de la valeur de la tension appliquée au condensateur de mémorisation une fraction de la tension appliquée aux bornes du second condensateur.

Cet échantillonneur-bloqueur est particulièrement adapté à la compensation des défauts inhérents à son condensateur de mémorisation.

Ce dispositif selon l'invention est adapté à échantillonner tout signal avec un taux d'erreur réduit. Il est caractérisé en ce qu'il comporte un premier élément d'échantillonnage auquel le signal à échantillonner est appliqué et un second élément d'échantillonnage, dont la période d'échantillonnage est retardée, par rapport à celle du premier, d'un intervalle de temps inférieur à leur temps d'acquisition propre, des moyens d'amplification pour appliquer un gain d'amplification à la différence entre l'amplitude dudit signal à l'entrée du premier élément et du signal à la sortie de celui-ci, la sortie des moyens d'amplification étant connectée à l'entrée du second élément, et des moyens de sommation pour ajouter au signal issu du premier élément, une fraction seulement du signal issu du second élément de manière à réduire les erreurs appliquées aux échantillons de signal par le second élément.

Le dispositif selon l'invention a pour effet de diminuer fortement tous les défauts introduits par un échantillonneur-bloqueur, qu'ils soient dus à son condensateur de mémorisation ou aux éléments électroniques associés à ce condensateur. Il permet d'éviter le recours à des échantillonneurs-bloqueurs de fabrication hybride qui sont coûteux et consomment beaucoup de courant électrique, ce qui est difficilement compatible avec la fabrication de systèmes d'acquisition complexes où une multiplicité de boitiers d'acquisition incluant de tels échantillonneurs-bloqueurs sont répartis tout le long d'une flûte sismique de très grande longueur.

Les avantages du dispositif apparaîtront mieux à la lecture de la description qui va suivre concernant un mode de réalisation donné à titre d'exemple non limitatif, en se référant aux dessins annexés sur lesquels :
– la figure 1 montre un exemple connu de réalisation d'un échantillonneur-bloqueur ;
– la figure 2 montre un chronogramme de la tension de commande d'un échantillonneur-bloqueur, permettant la mémorisation intermittente d'un signal à échantillonner ;
– la figure 3 montre les variations respectives d'un signal appliqué à l'entrée d'un échantillonneur-bloqueur et du signal correspondant aux bornes du condensateur de mémorisation de celui-ci ;
– la figure 4 montre de façon approximative la variation de l'erreur introduite par un échantillonneur-bloqueur en fonction de la différence d'amplitude entre deux échantillons successifs de signal ;
– la figure 5 représente un mode préféré de réalisation du dispositif selon l'invention, et
– les figures 6 et 7 montrent respectivement les chronogrammes des signaux de commande des deux échantillonneurs-bloqueurs inclus dans le dispositif de la figure 5.

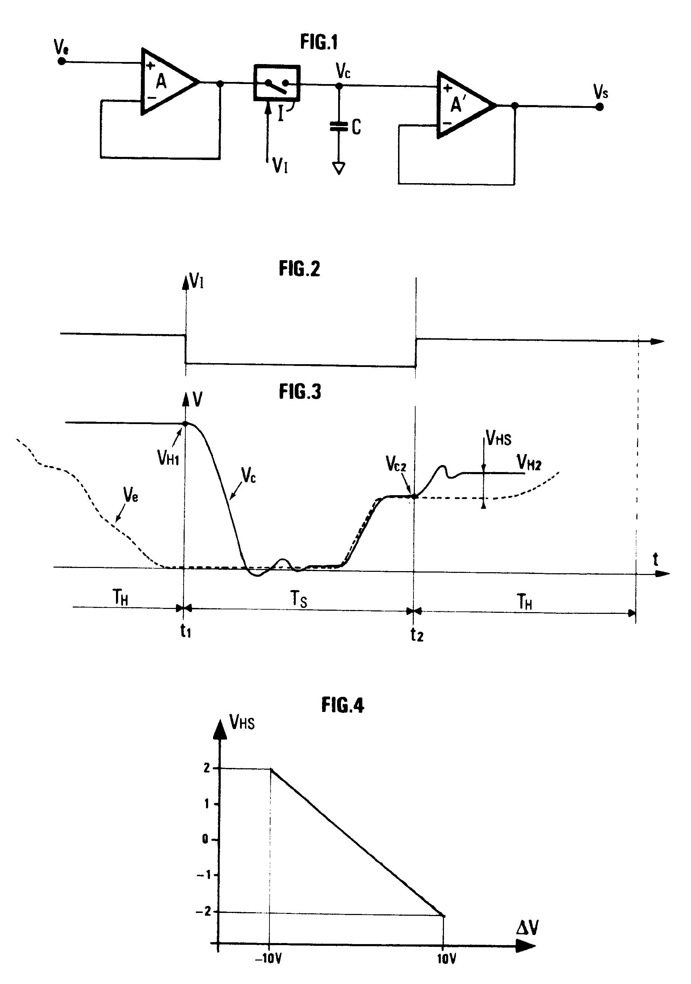

L'échantillonneur-bloqueur d'un type connu illustré à la figure 1 comporte deux amplificateurs opération-

EP 0 319 414 B1

nels A et A′ disposés en série, la sortie du premier étant connectée par un interrupteur I, de préférence électronique à l'entrée non inverseuse du second amplificateur A′, laquelle est également connectée à la masse par l'intermédiaire d'un condensateur C. L'impédance de sortie du premier amplificateur A est faible alors que l'impédance d'entrée du second est très élevée. Le premier amplificateur A est un amplificateur d'isolement à gain unité dont le signal de sortie reproduit le signal $V_e$ appliqué à son entrée non inverseuse.

Durant un intervalle de temps $T_H$ de blocage finissant à un instant $t_1$ (Fig.2, 3), l'interrupteur I est ouvert. L'impédance d'entrée de l'amplificateur A′ étant très grande, la tension Vc se maintient pratiquement à une valeur constante $V_{H1}$ pendant cet intervalle de temps dit de blocage. Elle correspond à la valeur de l'échantillon prise à un instant plus tôt. On suppose que, pendant cet intervalle de blocage $T_H$, le signal d'entrée $V_e$ a décru très rapidement du fait qu'il possède une grande dynamique de variation. A l'instant $t_1$ et jusqu'à un instant ultérieur $t_2$, on applique un signal de commande $V_I$ (Fig.2) à l'interrupteur I, de manière à fermer celui-ci. L'intervalle de temps $(t_1, t_2)$ définit une période d'échantillonnage $T_S$. La tension Vc décroît jusqu'à rejoindre la tension d'entrée et la suite dans ses variations. Mais à l'instant $t_2$ où l'on ouvre de nouveau l'interrupteur I (nouvelle période de blocage $T_H$), on constate que la tension $V_c$ et par conséquent la tension $V_s$ à la sortie de l'amplificateur $A_2$, au lieu de conserver la valeur $V_{C_2}$ atteinte à la fin de l'intervalle d'échantillonnage $T_S$, subit une brusque variation et se fixe à une valeur réelle $V_{H_2}$. On constate également que l'écart $V_{H_s}$ entre les tensions $V_{H_2}$ et $V_{C_2}$ dépend de la variation d'amplitude $\Delta V$ subie par le signal d'entrée depuis l'instant d'échantillonnage précédent. En général cette variation $\Delta V$ est sensiblement linéaire (Fig.4).

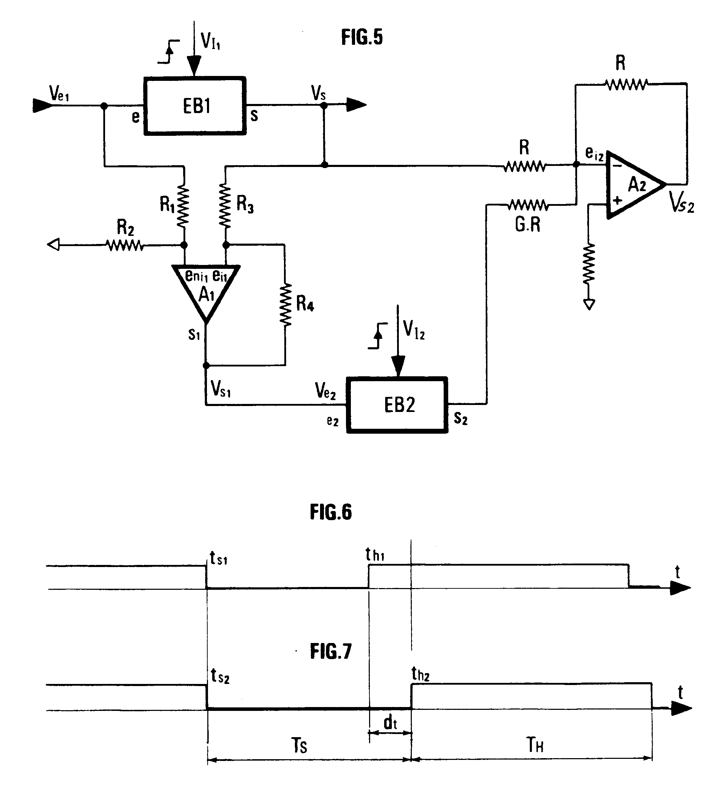

L'erreur $V_{H_s}$ résulte de plusieurs causes différentes. La plus notable tient aux imperfections du condensateur de mémorisation C qui est équivalent à un condensateur théorique sans perte connecté en parallèle à un circuit comprenant une résistance en série avec un condensateur. L'erreur $V_{H_s}$ tient aussi à la non linéarité des étages amplificateurs tels que A ou A′ ainsi qu'aux défauts propres aux interrupteurs électroniques I associés. La réduction de cette erreur devient nécessaire quand on emploie un convertisseur analogique-numérique à grande dynamique (délivrant par exemple des mots numériques de 15 bits). L'ensemble d'échantillonnage et de blocage représenté à la figure 5 permet de réduire très fortement les écarts $V_{H_s}$, qu'ils soient dus aux condensateurs de mémorisation ou aux éléments électroniques associés.

Il comporte un premier échantillonneur-bloqueur $EB_1$ capable d'assurer durant toutes ses phases de blocage, une bonne mémorisation de la tension $V_e$ qui lui est appliquée. Le signal à l'entrée e, de l'élément $EB_1$ et le signal s disponible à la sortie du même élément, sont appliqués respectivement à l'entrée non inverseuse $eni_1$ et à l'entrée inverseuse $ei_1$ d'un amplificateur différentiel $A_1$ dont le gain a une valeur prédéterminée G. L'application de ces deux signaux est effectuée par l'intermédiaire d'un réseau classique de quatre résistances électriques. Deux d'entre elles ($R_1$, $R_2$) disposées en série, connectent l'entrée à la masse. Leur point milieu est connecté à l'entrée non inverseuse eni1. Les deux autres ($R_3$, $R_4$) disposées en série, relient la sortie s à la sortie $s_1$ de l'amplificateur $A_1$ et leur point milieu est connecté à l'entrée inverseuse $ei_1$.

La sortie $s_1$ de l'amplificateur $A_1$ est connectée à l'entrée $e_2$ d'un second échantillonneur-bloqueur $EB_2$ dont il s'agit de corriger les erreurs. La sortie de l'élément $EB_1$ est connectée également à l'entrée inverseuse $ei_2$ d'un second amplificateur $A_2$ par l'intermédiaire d'une résistance R. Cette même entrée $ei_2$ est aussi connectée d'une part à la sortie $s_2$ de l'élément $EB_2$, par une résistance de valeur GR, G étant le gain du premier amplificateur $A_1$.

Un signal de commande $VI_1$ est appliqué au premier échantillonneur-bloqueur $EB_1$ sur son entrée de commande pour provoquer alternativement la fermeture de son interrupteur interne I (Fig.1) aux instants $ts_1$ (début de la période d'échantillonnage) et son ouverture aux instants $th_1$ (début de la période de blocage et mémorisation). De la même façon, un signal de commande $VI_2$ est appliqué au second échantillonneur-bloqueur $EB_2$, sur son entrée de commande $VI_2$ pour provoquer alternativement la fermeture (instant $ts_2$) et l'ouverture (instant $th_2$) de son interrupteur interne. Le signal de commande est tel que l'instant $th_2$ est décalé dans le temps par rapport à l'instant $t_{h1}$ d'un intervalle dt supérieur à la durée d'acquisition propre de chaque échantillonneur-bloqueur, est appliqué au second d'entre eux ($EB_2$), sur son entrée de commande.

Le dispositif fonctionne de la manière suivante :

On désigne par $V_{e_H}$ la valeur de la tension d'entrée Ve$_1$ mémorisée à un instant de blocage quelconque $th_1$ de l'échantillonneur-bloqueur $EB_1$ et par $V_{HS_1}$ l'amplitude de l'erreur introduite par celui-ci. A partir de cet instant $th_1$, la tension appliquée à l'entrée inverseuse $ei_1$ de l'amplificateur $A_1$ est égale à $(V_{eH} + V_{HS_1})$. La tension d'entrée $V_{e_1}$, est continuellement variable. On désigne par $(V_{e_H} + u)$ sa valeur à l'instant ultérieur $th_2$ où l'on commande le blocage de l'échantillonneur-bloqueur $EB_2$. Cette valeur étant alors appliquée à l'entrée non inverseuse eni$_1$ de l'amplificateur $A_1$, la tension $V_{S_1}$ mesurable à la sortie $S_1$ de celui-ci, amplifiée avec un gain égal à G est :

$$V_{S1} = G (V_{eH} + u) - (V_{eH} + V_{HS1})$$

ou

$$V_{S1} = G (u - V_{HS1}) \quad (1)$$

3

La tension $V_{S1}$ est mémorisée par l'échantillonneur-bloqueur EB2 qui lui applique une erreur que l'on désigne par $V_{HS2}$.

A l'entrée inverseuse ei2 de l'amplificateur $A_2$ sont donc appliquées la tension $(V_{eH} + V_{HS1})$ d'une part et la tension $(V_{S1} + V_{HS2})$ divisée dans un rapport 1/G. La tension mesurable à la sortie $V_{S2}$ du second amplificateur $A_2$ s'exprime donc :

$$V_{S2} = -\left[\frac{G}{G}\ (u\ -\ V_{HS1}) \ +\ \frac{V_{HS2}}{G}\ +\ (V_{EH}\ +\ V_{HS1})\right]$$

qui, en simplifiant devient :

$$V_{S2} = (V_{eH}\ +\ u)\ +\ \frac{V_{HS2}}{G} \quad (2)$$

$(V_{eH} + u)$ représentant la valeur mémorisée à l'instant de blocage $t_{h2}$ du second élément EB2, on voit que la valeur finale disponible à la sortie du dispositif : $(V_{eH2} + V_{HS2/G})$ n'est plus affectée que d'une erreur d'amplitude $V_{HS2/G}$ et donc divisée dans un rapport G par rapport à celle que l'on observerait à la sortie de l'échantillonneur-bloqueur EB2 s'il était utilisé seul. Cette diminution affecte les erreurs introduites qu'elles qu'en soient leur cause.

La valeur maximale qu'il est possible de donner au gain G pour minimiser au mieux les tensions d'erreur, est déterminée en fonction de la fréquence maximale des signaux Ve, appliqués à l'entrée du dispositif et de l'intervalle $\tau$ d'acquisition propre des échantillonneurs-bloqueurs, pour que la tension $V_{S1}$ (relation 1) n'excède jamais la tension maximale mémorisable par l'élément EB2. La réduction de la tension d'erreur opérée par le dispositif sera meilleure si la fréquence d'échantillonnage des signaux n'est pas trop élevée. C'est le cas par exemple pour l'acquisition multiplexée des signaux délivrés par des récepteurs sismiques.

On ne sortirait pas du cadre de l'invention en donnant une valeur différente au produit du gain G de l'amplificateur A1 par le facteur de réduction de l'amplitude des échantillons issus du second échantillonneur-bloqueur.

## Revendications

1. Dispositif pour échantillonner un signal avec un taux d'erreur réduit, caractérisé en ce qu'il comporte un premier élément d'échantillonnage (EB1) auquel le signal à échantillonner est appliqué et un second élément d'échantillonnage (EB2) dont la période d'échantillonnage est retardée par rapport à celle du premier d'un intervalle de temps (dt) inférieur à leur temps d'acquisition propre, des moyens d'amplification (A1) pour appliquer un gain d'amplification (G) à la différence entre l'amplitude dudit signal à l'entrée du premier élément d'échantillonnage (EB1) et du signal à la sortie de celui-ci, la sortie des moyens d'amplification étant connectée à l'entrée du second élément d'échantillonnage (EB2) et des moyens de sommation (A2) pour ajouter au signal issu du premier élément d'échantillonnage (EB1), une fraction seulement du signal issu du second élément d'échantillonnage (EB2) de manière à réduire les erreurs appliquées aux échantillons de signal par le second élément d'échantillonnage (EB2).

2. Dispositif selon la revendication 1, caractérisé en ce que les moyens d'amplification comportent un premier amplificateur différentiel (A1) et les moyens de sommation comportent un second amplificateur sommateur (A2) associé à des résistances électriques dont les valeurs sont choisies pour appliquer au signal issu du second élément (EB2) un gain inférieur à celui appliqué au signal issu du premier élément (EB1).

3. Dispositif selon la revendication 2, caractérisé en ce que le rapport des gains appliqués respectivement aux signaux issus du premier élément (EB1) et du second élément (EB2) est choisi égal au gain du premier amplificateur (A1).

## Patentansprüche

1. Vorrichtung zur Abtastung eines Signals mit einer reduzierten Fehlerrate, dadurch *gekennzeichnet*, daß sie umfasst: ein erstes Abtastungselement (EB1), woran das abzutastende Signal angelegt wird und ein zweites Abtastungselement (EB2), dessen Abtastperiode bezogen auf die des ersten Elements mit einem Zeitintervall (dt), das kleiner ist als ihre eigenen Haltezeiten verzögert ist; Verstärkungsmittel (A1) zur Erlangung eines Verstärkungsfaktors (G) der Differenz zwischen dem genannten Signal am Eingang des ersten Abtastungselements (EB1) und dem Signal am Ausgang desselben, wobei der Ausgang der Verstärkungsmittel mit dem Eingang des zweiten Abtastungselements (EB2) verbunden ist; und Mittel zur Summenbildung (A2), um zu dem aus dem ersten Abtastungselement hervorgegangenen Signal nur einen Teil des aus dem zweiten Abtastungselement (EB2) hervorgegangenen Signals zu addieren derart, daß die bei den Abtastungen des Signals bewirkten Fehler durch das zweite Abtastungselement (EB2) reduziert werden.

2. Vorrichtung nach Anpruch 1, dadurch *gekennzeichnet*, daß die Verstärkungsmittel einen ersten Differenzverstärker (A1) und die Mittel zur Summenbildung einen zweiten Summenverstärker (A2), jeweils zugeordnet zu elektrischen Widerständen, umfassen, deren Werte gewählt werden, um für das aus dem zweiten Element (EB2) hervorgegangenen Signal eine niedrigere Verstärkung, als für das aus dem ersten Element (EB1) hervorgegangene Signal zu erlangen.

3. Vorrichtung nach Anspruch 2, dadurch *gekennzeichnet*, daß das Verhältnis der verwendeten Verstärkungsfaktoren jeweils für die aus dem ersten Element (EB1) und aus dem zweiten Element (EB2) hervorgegangenen Signale gleich zu dem Verstärkungsfaktor des ersten Verstärkers (A1) gewählt wird.

## Claims

1. Device for sampling a signal with a reduced rate of error, characterised in that it comprises a first sampling element (EB1) to which the signal to be sampled is applied and a second sampling element (EB2) where the period of sampling is delayed relative to that of the first element by an interval of time (dt) less than their inherent acquisition times, a means of amplification (A1) in order to apply a gain in amplification (G) to the difference between the amplitude of the said signal at the input of the first sampling element (EB1) and the signal at its output, the output of the means of amplification being connected to the input of the second sampling element (EB2) and the means of summation (A2) in order to add to the signal from the first sampling element (EB1) a fraction only of the signal from the second sampling element (EB2) in order to reduce the errors applied to the signal samples by the second sampling element (EB2).

2. Device in accordance with claim 1, characterised in that the means of amplification comprises a first differential amplifier (A1) and the means of summation comprises a second summing amplifier (A2) associated with electrical resistances where the values are chosen in order to apply, to the signal from the second element (EB2), a gain which is less than that applied to the signal from the first element (EB1).

3. Device in accordance with claim 2, characterised in that the ratio of the gains applied respectively to the signals from the first element (EB1) and from the second element (EB2) is chosen so that it is equal to the gain for the first amplifier (A1).

FIG.1

FIG.2

FIG.3

FIG.4

EP 0 319 414 B1

**FIG.5**

**FIG.6**

**FIG.7**

7